# EUROPEAN PATENT APPLICATION

(11) **EP 4 181 212 A1**
(43) Date of publication of application: **17.05.2023**
(21) Application number: 21207731.7
(22) Date of filing: 11.11.2021
(51) Int. Cl.: H01L 29/78, H01L 29/06

(54) **SEMICONDUCTOR DEVICE**

(71) Applicant: Infineon Technologies Dresden GmbH & Co . KG, 01099 Dresden (DE)
(72) Inventor: WIESINGER, Markus, 01099 Dresden (DE); KOWALIK-SEIDL, Katarzyna, 82008 Unterhaching (DE); TILKE, Armin, 01309 Dresden (DE); WILLMEROTH, Armin, 86316 Freiberg (DE)
(74) Representative: Westphal, Mussgnug & Partner, Patentanwälte mbB

(57) **Abstract**

A semiconductor device comprises a semiconductor body (100) comprising a first surface (101), a second surface (102) opposite to the first surface (101) in a vertical direction (y), an active region (220), and a sensor region (230) arranged adjacent to the active region (220) in a horizontal direction (x, z), a plurality of transistor cells (30_{T}) at least partly integrated in the active region (220), each transistor cell (30_{T}) comprising a source region (31), a body region (32), a drift region (35) separated from the source region (31) by the body region (32), and a gate electrode (33) dielectrically insulated from the body region (32), at least one sensor cell (30s) at least partly integrated in the sensor region (230), each of the at least one sensor cell (30s) comprising a source region (31), a body region (32), a drift region (35) separated from the source region (31) by the body region (32), and a gate electrode (33) dielectrically insulated from the body region (32), and an intermediate region (240) arranged between the active region (220) and the sensor region (230), the intermediate region (240) comprising a drift region (35) and an undoped semiconductor region (39) extending from the first surface (101) into the drift region (35).

## Description

### TECHNICAL FIELD

The instant disclosure relates to a semiconductor device, in particular to an arrangement comprising a transistor device and a current detection element.

### BACKGROUND

Semiconductor devices such as insulated gate power transistor devices, e.g., power MOSFETs (Metal Oxide Semiconductor Field-Effect Transistors) or IGBTs (Insulated Gate Bipolar Transistors), are widely used as electronic switches in various types of electronic applications. In many applications such as high current applications, for example, a current through the semiconductor device is measured. Such current measurements are often performed by determining a voltage over an external shunt resistor. Such an external resistance, however, adds to the overall losses of the arrangement and may reduce the efficiency.

It is desirable to provide a semiconductor device comprising a current detection element that has low losses and may be operated effectively.

### SUMMARY

One example relates to a semiconductor device including a semiconductor body including a first surface, a second surface opposite to the first surface in a vertical direction, an active region, and a sensor region arranged adjacent to the active region in a horizontal direction, a plurality of transistor cells at least partly integrated in the active region, each transistor cell including a source region, a body region, a drift region separated from the source region by the body region, and a gate electrode dielectrically insulated from the body region, at least one sensor cell at least partly integrated in the sensor region, each of the at least one sensor cell including a source region, a body region, a drift region separated from the source region by the body region, and a gate electrode dielectrically insulated from the body region, and an intermediate region arranged between the active region and the sensor region, the intermediate region including a drift region and an undoped semiconductor region extending from the first surface into the drift region.

One example relates to a method for forming a semiconductor device, the method including forming a plurality of transistor cells in a semiconductor body, the semiconductor body including a first surface, a second surface opposite to the first surface in a vertical direction, an active region, and a sensor region arranged adjacent to the active region in a horizontal direction, wherein the plurality of transistor cells is at least partly integrated in the active region, and wherein each transistor cell includes a source region, a body region, a drift region separated from the source region by the body region, and a gate electrode dielectrically insulated from the body region, forming at least one sensor cell, wherein the at least one sensor cell is at least partly integrated in the sensor region, and wherein each of the at least one sensor cell includes a source region, a body region, a drift region separated from the source region by the body region, and a gate electrode dielectrically insulated from the body region, and forming an intermediate region between the active region and the sensor region, the intermediate region including a drift region and an undoped semiconductor region extending from the first surface into the drift region.

Examples are explained below with reference to the drawings. The drawings serve to illustrate certain principles, so that only aspects necessary for understanding these principles are illustrated. The drawings are not to scale. In the drawings the same reference characters denote like features.

### BRIEF DESCRIPTION OF THE DRAWINGS

Figure 1 schematically illustrates a cross sectional view of a semiconductor body.
Figure 2 schematically illustrates a cross sectional view of another semiconductor body.
Figure 3 shows an equivalent circuit diagram of a transistor device and an external current sense resistor.
Figure 4 shows an equivalent circuit diagram of a transistor device and a current detection device according to an example.
Figure 5 schematically illustrates a top view of a semiconductor arrangement according to an example.
Figure 6 schematically illustrates a top view of a semiconductor arrangement according to another example.
Figure 7 schematically illustrates a cross sectional view of a semiconductor device according to an example.
Figure 8 schematically illustrates a cross sectional view of a semiconductor device according to another example.
Figure 9 schematically illustrates a top view of a section of a semiconductor arrangement according to another example.
Figure 10 schematically illustrates a cross sectional view of a semiconductor device according to another example.
Figure 11 schematically illustrates a cross sectional view of a semiconductor device according to another example.
Figure 12 schematically illustrates a cross sectional view of a semiconductor device according to another example.
Figure 13 schematically illustrates a cross sectional view of a semiconductor device according to another example.
Figure 14 schematically illustrates a cross sectional view of a semiconductor device according to another example.

### DETAILED DESCRIPTION

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

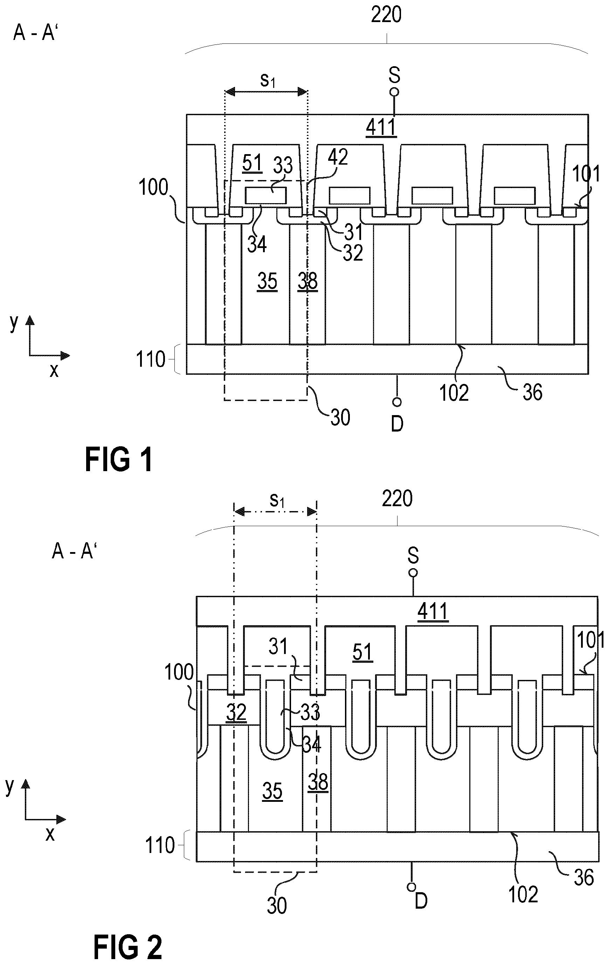

Referring to Figure 1, a cross-sectional view of a semiconductor device comprising a semiconductor body 100 is schematically illustrated. The semiconductor body 100 may include a conventional semiconductor material such as, for example, silicon (Si), silicon carbide (SiC), gallium nitride (GaN), gallium arsenide (GaAs), or the like. A transistor device is formed in the semiconductor body 100, the transistor device being arranged in an active region 220 of the semiconductor body 100. In Figure 1, only a small section of the transistor device is shown. In its active region 220, the semiconductor body 100 includes at least one working transistor cell 30 with a gate electrode 33 that is dielectrically insulated from a body region 32 by a gate dielectric 34. The body region 32 is a doped semiconductor region in the active region 220 of the semiconductor body 100. In the example illustrated in Figure 1, the body region 32 extends from a first surface 101 into the semiconductor body 100, and the gate electrode 33 is arranged above the first surface 101 of the semiconductor body 100. Each of the transistor cells 30 further includes at least one source region 31 extending from the first surface 101 into the body region 32.

The transistor device illustrated in Figure 1 further includes a drift region 35 formed in the semiconductor body 100. The drift region 35 adjoins the body region 32 of the at least one transistor cell 30 and forms a pn-junction with the body region 32. The drift region 35 is arranged between the body region 32 of the at least one transistor cell 30 and a semiconductor layer 110. The semiconductor layer 110 is arranged between a second surface 102 of the semiconductor body 100 and the drift region 35. The second surface 102 is arranged opposite to the first surface 101 in a vertical direction y of the semiconductor body 100.

The semiconductor layer 110 comprises a drain region 36 of the same doping type as the drift region 35 and adjoining the second surface 102. Optionally, a vertical field-stop-region (not specifically illustrated in Figure 1) of the same doping type as the drift region 35 and the drain region 36, but less highly doped than the drain region 36, may be arranged between the drift region 35 and the drain region 36. That is, the semiconductor layer 110 may be formed by the drain region 36 and the adjoining vertical field-stop-region. Such a vertical field-stop-region may be formed by a single layer or by a plurality of separate sub-layers, e.g., at least two sub-layers. Sub-layers that are arranged closer to the drift region 35 may be less highly doped than sub-layers that are arranged further away from the drift region 35. For example, a doping concentration of a sub-layer that is arranged adjacent to the drift region 35 may be selected from a range of between 1E15 and 1E16 cm⁻³ or lower. A doping concentration of a sub-layer that is arranged adjacent to the drain region 36 may be higher than a doping concentration of a sub-layer that is arranged horizontally above. The doping concentration of the sub-layer that is arranged adjacent to the drain region 36, however, may be lower than a doping concentration of the drain region 36. Generally speaking, a doping concentration of the different sub-layers may increase from the drift region 35 towards the drain region 36.

Still referring to Figure 1, the transistor device includes at least one vertical compensation region 38 of a doping type complementary to the doping type of the drift region 35. According to one example, the transistor device includes a plurality of transistor cells 30 and each transistor cell 30 includes a vertical compensation region 38 adjoining the body region 32 of the respective transistor cell 30. In a vertical direction y of the semiconductor body 100, which is a direction perpendicular to the first surface 101 and to the second surface 102, the at least one vertical compensation region 38 extends from the body region 32 into the semiconductor body 100 towards the semiconductor layer 110.

Still referring to Figure 1, the transistor device further includes a first source electrode 411. The first source electrode 411 is electrically connected to the source region 31 and the body region 32 of the at least one transistor cell 30 by means of contact plugs 42. The contact plugs 42 may comprise at least one of polysilicon, tungsten, aluminum, copper, and a Ti/TiN barrier liner, for example. This first source electrode 411 forms a source node S or is electrically connected to a source node S of the transistor device. The transistor device further includes a drain node D electrically connected to the drain region 36. A drain electrode electrically connected to the drain region 36 may form the drain node D.

The transistor device can be an n-type transistor device or a p-type transistor device. The device type is defined by the doping type of the source region 31. In an n-type transistor device, the source region 31 is an n-type region, the body region 32 is a p-type region, the drift region 35, which has a doping type complementary to the doping type of the body region 32, is an n-type region, and the at least one vertical compensation region 38 is a p-type region. In a p-type transistor device, the source region 31 is a p-type region, the body region 32 is an n-type region, the drift region 35 is a p-type region, and the at least one vertical compensation region 38 is an n-type region. The transistor device can be implemented as a MOSFET, for example. In a MOSFET, the drain region 36 has the same doping type as the drift region 35, as has been described above. For example, a doping concentration of the drain region 36 is selected from a range of between 1E18 and 1E19 cm⁻³, 1E18 and 1E20 cm⁻³, or 1E18 and 1E21 cm⁻³, doping concentrations of the drift region 35 and the vertical compensation region 38 are selected from a range of between 1E15 and 5E16 cm⁻³, and a doping concentration of the body region 32 is selected from between 5E16 cm⁻³ and 5E17 cm⁻³. The transistor cells 30 illustrated in Figure 1 are planar transistor cells. Implementing the transistor cells 30 as planar transistor cells, however, is only one example. According to another example, as is illustrated in Figure 2, the transistor cells 30 are implemented as trench transistor cells. That is, the at least one gate electrode 33 is arranged in a trench that extends from the first surface 101 into the semiconductor body 100.

In the transistor devices explained with respect to Figures 1 and 2 above, a plurality of transistor cells 30 is connected in parallel. That is, the source regions 31 of these transistor cells 30 are connected to the source node S, the common drain region 36 is connected to the drain node D, and the at least one gate electrode 33 is connected to a gate node.

The contact plugs 42 that are arranged below the first source electrode 411 extend from the source and body regions 31, 32 through an insulation layer 51 that is formed on the top surface 101 of the semiconductor body 100 to the first source electrode 411 to electrically couple the source and body regions 31, 32 to the first source electrode 411. In Figures 1 and 2, the insulation layer 51 is illustrated as a single continuous layer which extends from the first surface 101 of the semiconductor body 100 to the first source electrode 411. This, however, is only an example. Often, a gate oxide layer with a thickness of, e.g., 5nm to 200nm or 40nm to 120nm, is arranged on the first surface 101 of the semiconductor body 100. The insulation layer 51 may comprise this gate oxide layer and an additional layer which is formed on top of this gate oxide layer. This additional layer may comprise an undoped TEOS (tetraethyl orthosilicate) which may have a thickness of about 50nm to 500nm, and a doped BPSG (borophosphosilicate glass) having a thickness of about 200nm to 2µm or 1100nm to 1300nm, for example. The insulation layer 51, therefore, may comprise several sub-layers.

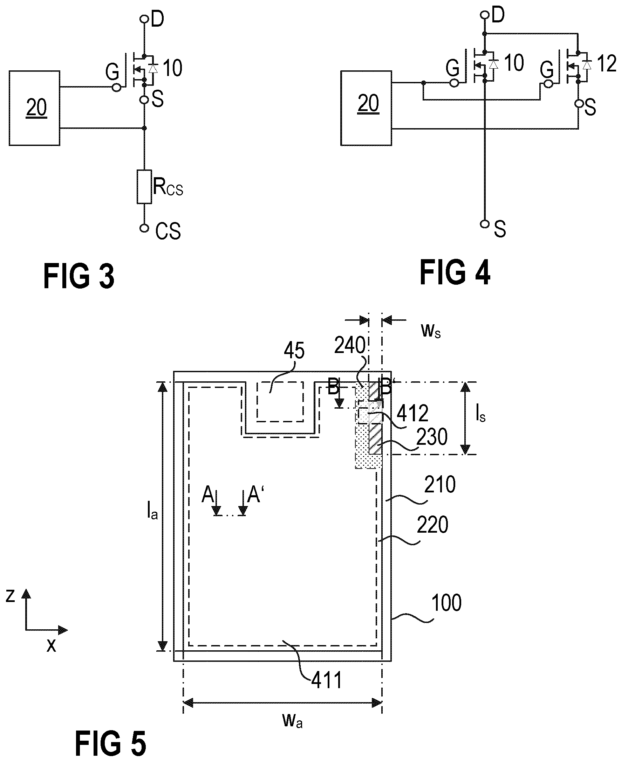

In many applications such as high current applications, for example, a current through the transistor device 10 is measured. Such current measurements are often performed by determining a voltage over an external shunt resistor R_{CS}, as is schematically illustrated in the circuit diagram of Figure 3. The voltage over the shunt resistor R_{CS}, and the current through the transistor device 10 may be determined by means of a controller 20, for example. Such an external shunt resistor R_{CS}, however, adds to the overall losses of the arrangement and may reduce its efficiency.

According to one example, therefore, the current through the transistor device 10 is determined by means of a current detection element 12. This is schematically illustrated in the circuit diagram of Figure 4. In this case, an external shunt resistor R_{CS} is no longer required. The current detection element 12 may be integrated in the same semiconductor body 100 as the transistor device 10, as will be described in more detail further below. The current detection element 12 may comprise an additional transistor device. A gate electrode G of the additional transistor device may be electrically coupled to a gate electrode G of the transistor device 10. The gate electrodes G of the transistor device 10 and the additional transistor device may be coupled to the controller 20. A drain electrode D of the additional transistor device may be electrically coupled to a drain electrode D of the transistor device 10. A source electrode S of the additional transistor device may be coupled to the controller 20. A source electrode S of the transistor device 10 is separate from and not electrically coupled to the source electrode of the additional transistor device.

Now referring to Figure 5, a top view of an exemplary semiconductor arrangement in a semiconductor body 100 is schematically illustrated. As has been described with respect to Figures 1 and 2 above, the transistor device is arranged in an active region 220 of the semiconductor body 100. Figures 1 and 2 illustrate exemplary cross-sectional views of a part of the transistor device along a section line A - A' as indicated in Figure 5.

A semiconductor body 100 usually comprises not only an active region 220, but also an inactive region, also referred to as passive region or edge (termination) region 210. The semiconductor arrangement, that is, the plurality of transistor cells 30, may be implemented within the active region 220 of the semiconductor body 100. An edge region 210, e.g., may be a region adjacent to the horizontal edges (outer edges) of the semiconductor body 100 (edge region). The outer edges extend in the vertical direction y between the first surface 101 and the second surface 102 and are essentially perpendicular to the first surface 101 and the second surface 102. A semiconductor body 100 having a rectangular or square cross section, for example, generally comprises four outer edges. According to one example and as is schematically illustrated in Figure 5, the active region 220 is horizontally surrounded by the edge region 210. The edge region 210 generally does not comprise any working transistor cells 30. In particular, an edge region 210 may be a region that does not include all active components that are necessary to form a functioning (working) transistor cell 30. Active components are, e.g., gate oxide, source regions 31, body regions 32, gate electrodes 33, or drain regions 36. For example, the edge region 210 may be a region within the semiconductor body 100 which does not comprise any source regions 31.

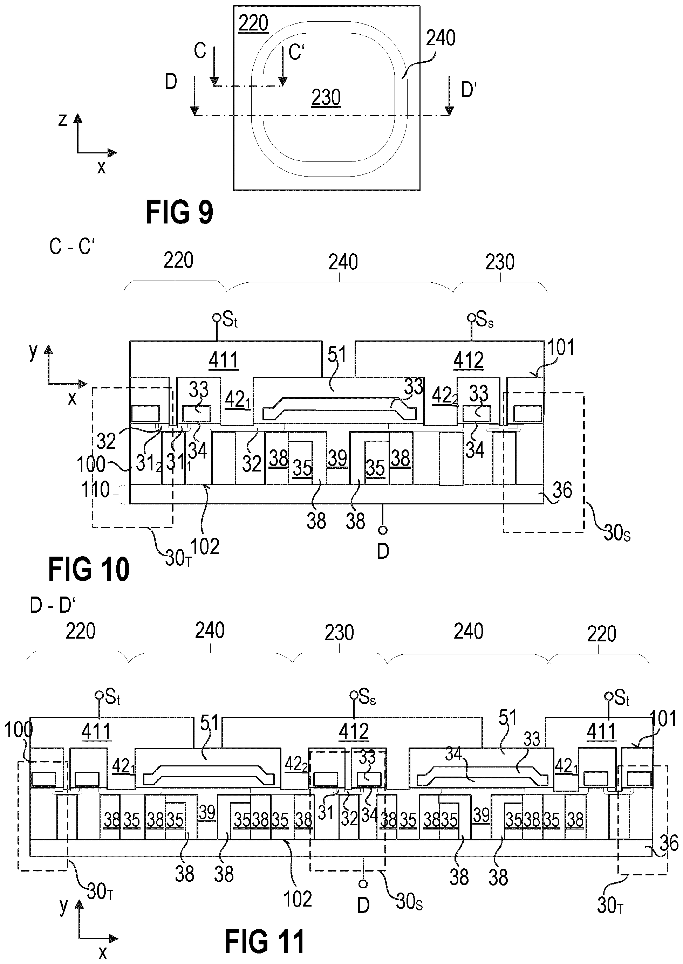

The first source electrode 411 and a gate electrode 45 are arranged on the semiconductor body 100 (electrodes indicated in dashed lines in Figure 5). The first source electrode 411 may be arranged on the active region 220 of the semiconductor body 100, for example. In addition to the transistor device comprising a plurality of transistor cells 30, the semiconductor device further comprises at least one sensor cell. The at least one sensor cell may be at least partly arranged in a sensor region 230 (crosshatched area in Figure 5). The sensor region 230 may also comprise at least one working transistor cell, similar to the active region 220. In the example illustrated in Figure 5, the sensor region 230 adjoins both the active region 220 and the edge region 210 on two sides each. This, however, is only an example. According to another example, the sensor region 230 may be horizontally surrounded by the active region 220 on three or four sides (see, e.g., Figure 9). That is, the sensor region 230 may adjoin the active region 220, but not the edge region 210, or may only adjoin the edge region 210 on one side. As will be described in further detail below, the at least one sensor cell arranged in the sensor region 230 may be electrically coupled to a second source electrode 412. The second source electrode 412 may be arranged on the same side of the semiconductor body 100 as the first source electrode 411. The second source electrode 412 may be arranged distant from the first source electrode 411 such that the first source electrode 411 and the second source electrode 412 are not electrically coupled to each other and may be contacted individually.

The semiconductor body 100 may have a rectangular form, for example. Other forms such as a square form, for example, however are also possible. The active region 210 may have a maximum width wa in a first horizontal direction x, and a maximum length lₐ in a second horizontal direction z perpendicular to the first horizontal direction x. The sensor region 230 may have a width ws in the first horizontal direction, and a length lₛ in the second horizontal direction z.

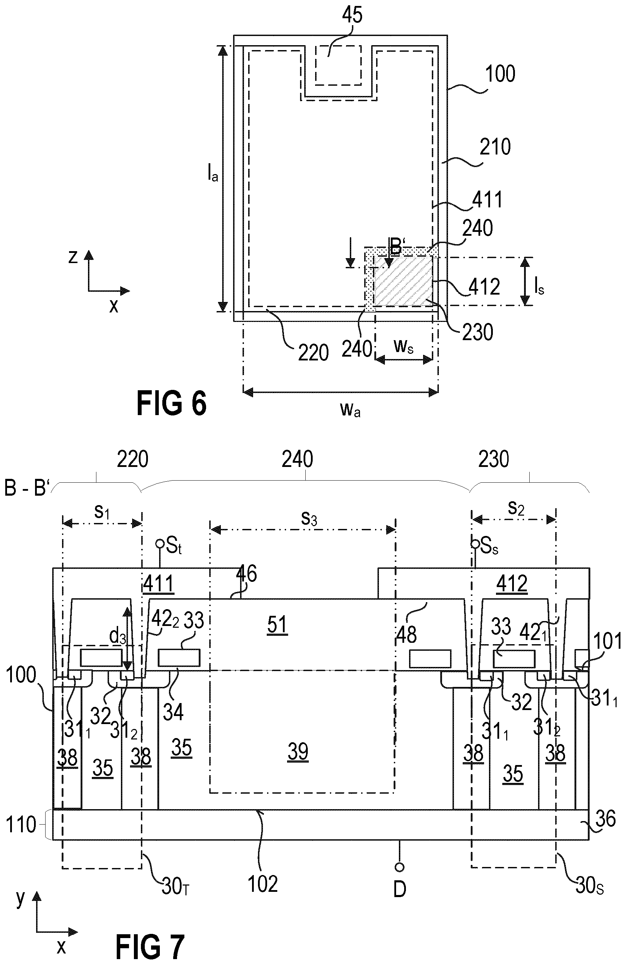

The width ws of the sensor region 230 may essentially correspond to the width _{S2} of a single sensor cell 30s. According to another example, the sensor region 230 may comprise a plurality of sensor cells 30s such that the width ws of the sensor region 230 is several times the width _{S2} of a single sensor cell 30s (see, e.g., Figure 6). The length lₛ of the sensor region 230 may correspond to the length lₛ of the one or more sensor cells 30s. The length lₛ of the sensor region 230 may be significantly shorter than the length lₐ of the active region 220. The sensor region 230 may be arranged in any suitable position of the semiconductor body 100. A sensor cell 30s will be described in further detail with respect to Figure 7 in the following.

In the cross-sectional view of Figure 7, a transistor cell 30_{T} is schematically illustrated. The transistor cell 30_{T} essentially corresponds to the transistor cells 30 that have been described with respect to Figures 1 and 2 above. The semiconductor device illustrated in Figure 7 further comprises a sensor cell 30s. The sensor cell 30s also essentially corresponds to the transistor cells 30 that have been described with respect to Figures 1 and 2 above. That is, the sensor cell 30s comprises a gate electrode 33 that is dielectrically insulated from a body region 32 by a gate dielectric 34. In the example illustrated in Figure 7, the body region 32 extends from the first surface 101 into the semiconductor body 100, and the gate electrode 33 is arranged above the first surface 101 of the semiconductor body 100. According to another example, similar to the transistor cells 30 illustrated in Figure 2, the sensor cell 30s may alternatively be implemented as trench transistor cell. That is, the at least one gate electrode 33 may be arranged in a trench that extends from the first surface 101 into the semiconductor body 100. Each of the at least one sensor cell 30s further includes at least one source region 31 extending from the first surface 101 into the body region 32. The source regions of the at least one sensor cell 30s are coupled to the second source electrode 412.

The sensor cell 30s illustrated in Figure 7 further includes a drift region 35 formed in the semiconductor body 100. The drift region 35 adjoins the body region 32 of the at least one sensor cell 30s and forms a pn-junction with the body region 32. The drift region 35 is arranged between the body region 32 of the at least one sensor cell 30s and the semiconductor layer 110. Each of the at least one sensor cell 30s further comprises a compensation region 38 of a doping type complementary to the doping type of the drift region 35 and extending from a respective body region 32 into the drift region 35 in the vertical direction y.

The gate electrodes 33 of the plurality of transistor cells 30_{T} and the gate electrodes 33 of the at least one sensor cell 30s are coupled to a common gate pad 45, and the drift regions 35 of the plurality of transistor cells 30_{T} and the drift regions 35 of the at least one sensor cell 30s are coupled to a common drain region 36. As has been described with respect to Figure 5 above, the source regions 31 of the at least one sensor cell 30s are coupled to a second source electrode 412 that is separate and distant from the first source electrode 411.

An intermediate region 240 is arranged between the active region 220 and the sensor region 230. The intermediate region 240, in the example illustrated in Figure 7, comprises a drift region 35 and an undoped semiconductor region 39, the undoped semiconductor region 39 extending from the first surface 101 into the drift region 35. A thin layer of the drift region 35, however, may be arranged below the undoped semiconductor region 39, between the undoped semiconductor region 39 and the semiconductor layer 110. The intermediate region 240 enables a satisfying thermal contact between the active region 210 and the sensor region 230 while, at the same time, providing sufficient electrical insulation between the active region 210 and the sensor region 230. An insufficient thermal coupling may result in a temperature dependence of the ratio of the currents through the transistor device 10 and the current detection element 12. An insufficient electrical insulation may have an undesired influence on the measured current through the current detection element 12, as the current may split between a desired measurement path and an undesired leakage path. This may negatively affect the accuracy of the measurements.

A width _{S3} of the intermediate region 240 may be between one and 20 times the first width si of a single transistor cell 30_{T}. According to one example, the width _{S2} of a single sensor cell 30s equals the first width si of a single transistor cell 30_{T}.

As has been described with respect to Figures 5 and 6 above, the sensor region 230 may be arranged between the active region 220 and the edge region 210. In the examples of Figures 5 and 6, the sensor region 230 is arranged in a corner of the semiconductor body 100 such that it adjoins the active region 210 on two sides. The intermediate region 240 in these examples, therefore, essentially has the shape of an "L", separating the sensor region 230 from the active region 210 on two horizontal sides. It is, however, also possible that the sensor region 230 adjoins the active region 220 on three or even on four sides. In such cases, the intermediate region 240 may have the shape of a "U" or may form a closed loop around the sensor region 230 (see, e.g., Figure 9).

In the example illustrated in Figure 5, the width ws of the sensor region 230 is comparably small as compared to a width of the second source electrode 412 in the same direction. That is, the second source electrode 412 at least partly covers the sensor region 230 as well as parts of the intermediate region 240 and, optionally, even parts of the active region 220.

Now referring to Figure 6, it is also possible that the width ws of the sensor region 230 essentially equals the width of the second source electrode 412 in the same direction. Even further, it is possible that the sensor region 230 and the second source electrode 412 have essentially the same size. That is, the second source electrode 412 may completely cover the sensor region 230. Optionally, the second source electrode 412 may additionally cover at least parts of the intermediate region 240 and parts of the active region 210.

A transition between the active region 220 and the intermediate region 240, as well as a transition between the sensor region 230 and the intermediate region 240 may be implemented in different ways. According to a first example, an outermost transistor cell 30_{T} and an outermost sensor cell 30s may each directly adjoin the undoped semiconductor region 39. The outermost transistor cell 30_{T} being that transistor cell 30_{T} of the plurality of transistor cells 30_{T} that is arranged closest to the intermediate region 240, and the outermost sensor cell 30s being that sensor cell 30s of the at least one sensor cell 30s that is arranged closest to the intermediate region 240. In this case, the intermediate region 240 effectively only comprises the undoped semiconductor region 39. It is, however, also possible that the intermediate region 240 further comprises a first transition zone arranged between the outermost transistor cell 30_{T} and the undoped semiconductor region 39, and a second transition zone arranged between the outermost sensor cell 30s and the undoped semiconductor region 39. Each of the first and second transition zones may comprise an incomplete transistor or sensor cell. That is, a transition zone may comprise some but not all active components that are necessary to form a functioning (working) transistor or sensor cell. Active components are, e.g., gate oxide, source regions 31, body regions 32, gate electrodes 33, or drain regions 36. In the example illustrated in Figure 7, each of the transition zones comprises a gate electrode 33, a body region 32, a drain region 36, a compensation region 38 and a drift region 35, but no source region 31.

In the example illustrated in Figure 7, a doping concentration of a subset of the transistor cells 30_{T} and a doping concentration of a subset of the sensor cells 30s may be adapted. That is, the semiconductor device may comprise a plurality of standard transistor cells 30_{T}, the drift region 35 of each of the plurality of standard transistor cells 30_{T} having a first doping concentration, and at least one standard sensor cell 30s, the drift region 35 of each of the at least one standard sensor cells 30s having a second doping concentration. According to one example, the first doping concentration equals the second doping concentration. It is, however, also possible that the first doping concentration differs from the second doping concentration. The semiconductor device further comprises at least two transition cells, the drift region 35 of each of the transition cells having a third doping concentration that is lower than the first doping concentration and lower than the second doping concentration. At least one of the transition cells is arranged between the intermediate region 240 and at least a subset of the plurality of standard transistor cells 30_{T}, and at least one of the transition cells is arranged between the intermediate region 240 and the at least one standard sensor cell 30s. In this way, the doping concentration of the drift regions 35 from the standard transistor cells 30_{T} towards the undoped semiconductor region 39 may be gradually reduced. Further, the doping concentration of the drift regions 35 from the standard sensor cells 30s towards the undoped semiconductor region 39 may be gradually reduced. If the standard transistor cells 30_{T} and the standard sensor cells 30s which have drift regions 35 with a comparably high doping concentration as compared to the undoped semiconductor region 39 directly adjoin the undoped semiconductor region 39, there is a risk that the doping compensation in the superjunction transistor cells is negatively affected. That is, in such a case there is a risk that the transistor device as well as the sensor device do not function properly.

According to one example, only one transition cell is arranged between the standard transistor cells 30_{T} and the intermediate region 240, and only one transition cell is arranged between the standard sensor cells 30s and the intermediate region 240. According to another example, a plurality of transition cells (e.g., between 2 and 4, or between 2 and 14) is arranged between the standard transistor cells 30_{T} and the intermediate region 240, wherein a doping concentration of the different transition cells decreases from the standard transistor cells 30_{T} towards the intermediate region 240. Further, a plurality of transition cells (e.g., between 2 and 4, or between 2 and 14) may be arranged between the standard sensor cells 30s and the intermediate region 240, wherein a doping concentration of the different transition cells decreases from the standard sensor cells 30s towards the intermediate region 240. Such a semiconductor device generally comprises a stable breakdown behavior in spite of the undoped semiconductor region 39 separating the active region 220 from the sensor region 230. The sensor region 230 and the intermediate region 240 separating the sensor region 230 from the active region 220 in this example generally require only a comparably small area on the semiconductor body 100. At the same time, a satisfactory thermal coupling between the active area 220 and the sensor area 230 can be achieved.

As is illustrated in Figures 5, 6 and 9, the sensor region 230 adjoins the active region 220 also at least along one of its edges in the second horizontal direction z. A doping concentration of such transistor cells 30_{T} adjoining the sensor region 230 in the second horizontal direction z may also decrease towards the intermediate region 240. The same applies for the sensor cells 30s in the second horizontal direction z towards the active region 220.

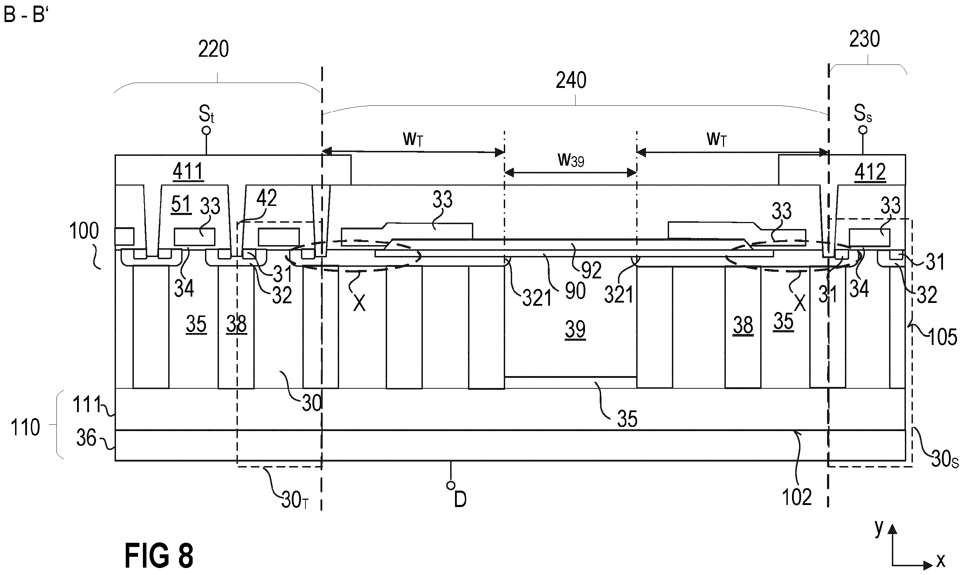

Now referring to Figure 8, it is also possible that the intermediate region 240, in addition to the undoped semiconductor region 39, comprises a first transition zone between the undoped semiconductor region 39 and the active region 220, and a second transition zone between the undoped semiconductor region 39 and the sensor region 230. Each of the first transition zone and the second transition zone may be similar to a conventional edge concept (e.g., intrinsic edge concept), as is usually arranged between the active region 220 and the edge region 210. The first transition zone in this example may comprise a base region 321 and a junction termination region 90 formed in the semiconductor body 100. The base region 321 extends from the first surface 101 into the semiconductor body 100 in the vertical direction y. In the horizontal direction, the base region 321 extends from the active region 220 to the undoped semiconductor region 39.

The base region 321 may be a depletable semiconductor region, i.e. a semiconductor region which is already substantially depleted when in an off-state a reverse voltage is applied between the drain node D and the source node S, reversely biasing the pn-junctions formed between adjoining drift regions 35 and compensation regions 38 which is lower than a rated breakdown voltage of the semiconductor device. Due to using a depletable base region 321, or at least a partly depletable base region 321, a major part of the first transition zone differs from the source potential at higher reverse voltage. Thus a reduction of the breakdown voltage may be avoided. "At least partly depletable" in this context refers to a base region 321 that is largely depletable. However, some sections of the base region 321 may not be depletable. For example, a section X of the base region 321 which directly adjoins a contact plug 42 that electrically couples the base region 321 to the source electrode 41 may not be depletable. This is, because this contact region in some applications should not be pinched off. Therefore, the section X forming the transition between the base region 321 and the contact plug 42 may be more highly doped than other sections of the base region 321 that are arranged further away from the contact plug 42. For example, a doping concentration of the base region 321 may decrease in the horizontal direction x from the contact plug 42 towards the undoped semiconductor region 39.

The base region 321 may be of the same doping type as the body regions 32. The doping concentration of the base region 321 is typically chosen such that the base region 321 is substantially depleted only above high enough reverse voltages of e.g. at least about a fifth or half of a rated breakdown voltage which is applied between the source node S and the drain node D. As has been described above, this may not be applicable for the section X of the base region 321 which may be more highly doped and, therefore, may not be depletable at all.

The second transition zone arranged between the sensor region 230 and the undoped semiconductor region 39 also comprises a base region 321 extending from the first surface 101 into the semiconductor body 100 in the vertical direction y, and from the sensor region 230 to the undoped semiconductor region 39 in the horizontal direction x.

The intermediate region 240 further comprises a junction termination region 90 extending from the first surface 101 into the semiconductor body 100 in the vertical direction y, and from the first transition zone to the second transition zone in the horizontal direction x. In particular, the junction termination region 90 extends from the first base region 321 to the second base region 321 such that it is arranged between the undoped semiconductor region 39 and the first surface 101. The junction termination region 90 partly overlaps with both the first base region 321 and the second base region 321. That is, in the first transition zone, the junction termination region 90 extends from the first surface 101 into the first base region 321, and in the second transition zone, the junction termination region 90 extends from the first surface 101 into the second base region 321.

The junction termination region 90 may also be a depletable region. The junction termination region 90 may be of the opposite doping type than the body regions 32 and the base regions 321 and may form a pn-junction with the base regions 321. The base regions 321 may have a larger width in the horizontal direction x as compared to the body regions 32. A vertically integrated dopant concentration of the junction termination region 90 may match or may be lower than a vertically integrated dopant concentration of the base regions 321. The junction termination region 90 may stabilize the transition zones against surface charges on the first surface 101.

The first source electrode 411 is electrically connected to the first base region 321 by means of a contact plug 42, and the second source electrode 412 is electrically connected to the second base region 321 by means of another contact plug 42. The contact plugs, similar to the contact plugs 42 connecting the first source electrode 411 and the source and body regions 31, 32 of the transistor cells 30_{T}, may comprise at least one of tungsten, aluminum, polysilicon, copper, and a Ti/TiN barrier liner, for example. The semiconductor device may further comprise a field oxide layer 92 that is arranged between the first surface 101 and the insulation layer 51 in the intermediate region, as is schematically illustrated in Figure 8.

The first transition zone and the second transition zone each may have a width w_{T} in the horizontal direction x of between 50µm and 200µm, for example. The undoped semiconductor region 39 may have a width w39 in the horizontal direction x of between 50µm and 150µm, for example.

The arrangement that has been described with respect to Figure 8 above generally requires more space as compared to the arrangement illustrated in Figure 7, resulting in higher cost requirements. The arrangement, however, has certain advantages with respect to the breakdown capability of the device.

As has already been stated above, there are different ways to implement the first source electrode 411 and the second source electrode 412. There are also different ways of electrically coupling the source regions 31 and the body regions 32 of the transistor cells 30_{T} to the first source electrode 411, and the source regions 31 and the body regions 32 of the sensor cells 30s to the second source electrode 412. In the example illustrated in Figure 10, which schematically illustrates a cross-sectional view of the semiconductor device of Figure 9 along a section line C - C' , the second source electrode 412 essentially covers the sensor region 230 and (optionally) parts of the intermediate region 240. The first source electrode 411 essentially covers the active region 220 and (optionally) parts of the intermediate region 240. Such sections of the first source electrode 411 and the second source electrode 412 that extend on the intermediate region 240 may act as field plates and limit the area that is accessible for mobile ion introduction. There is, however, a gap between the first source electrode 411 and the second source electrode 412 such that there is no electrical connection between the first and the second source electrode 411, 412. In this example, a first subset of the contact plugs 42₁ extends directly from the source regions 31 and body regions 32 of the transistor cells 30_{T} to the first source electrode 411. A second subset of the contact plugs 42₂ extends directly from the source regions 31 and body regions 32 of the sensor cells 30s to the second source electrode 412. A poly region 33 comprising polysilicon may be arranged in the insulation layer 51 and above the first surface 101. This poly region 33 may be formed of the same material as the gate electrodes 33 of the transistor cells 30_{T} and the sensor cells 30s. However, a length of this poly region 33 in the first horizontal direction x may be larger than a length of the gate electrodes 33 in the same direction.

In the example illustrated in Figure 10, the first transition zone and the second transition zone each include at least one compensation region 38, similar to the compensation regions of the transistor cells 30_{T} and the sensor cells 30s. According to one example and as is schematically illustrated in Figure 10, the undoped semiconductor region 39 may directly adjoin one of the compensation regions 38 on each side in the horizontal direction x. A small layer of the compensation region 38 may extend vertically above the following drift region 35 such that the drift region 35 that is arranged closest to the undoped semiconductor region 39 does not directly adjoin the first surface 101. The poly region 33 may extend above the undoped semiconductor region 39 and into the transition zones above at least one of the drift regions 35 and at least one of the compensation regions 38.

While Figure 10 only depicts one border between the active region 220 and the sensor region 230, Figure 11 schematically illustrates a larger section of a device along a section line D - D' (see Figure 9). In this example, the sensor region 230 is horizontally surrounded by the active region 220. Therefore, in the cross-section of Figure 11, two intermediate regions 240 can be seen. The sensor region 230 in this example only comprises a single sensor cell 30s. Otherwise, the device is similar to what has been described with respect to Figure 10 above.

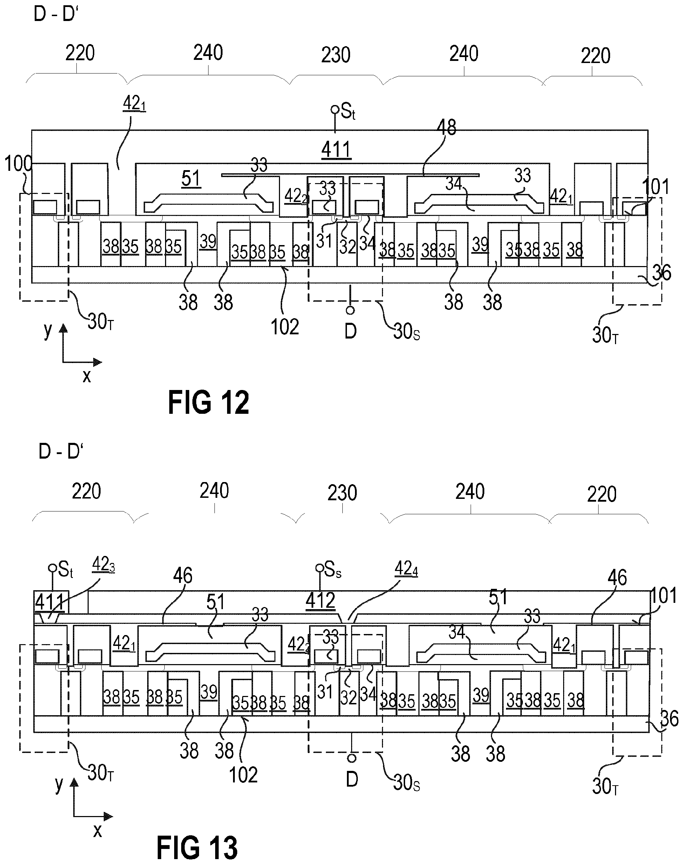

Now referring to Figure 12, it is also possible that the first source electrode 411 completely covers the sensor region 230. The device that is schematically illustrated in Figure 12 is similar to the device that has been described with respect to Figures 10 and 11 above. In particular, the components arranged between the first surface 101 and the second surface 102 are similar to what has been described above. The source regions 31 and body regions 32 of the transistor cells 30_{T}, similar to what has been described above, may be directly coupled to the first source electrode 411 by means of contact plugs 42i. The second source electrode 412 may be arranged in another section of the semiconductor body and is not visible in the cross-sectional view of Figure 12. In order to electrically couple the source regions 31 and body regions 32 of the sensor cells 30s to the second source electrode 412, the semiconductor device may comprise an additional conducting layer 48. This additional conducting layer 48 may be arranged above the first surface 101 and below the first source electrode 411. According to one example, the additional conducting layer 48 is arranged in the insulation layer 51 that is formed on the top surface 101 of the semiconductor body 100. That is, the additional conducting layer 48 is electrically insulated from the first source electrode 411 by means of a section of the insulation layer 51. The additional conducting layer 48 may be an elongated layer that has a length in the second horizontal direction z that is significantly larger (e.g., more than 10 times, or more than 100 times) than its width in the first horizontal direction x. While a first end of the additional conducting layer 48 may be arranged above the sensor region 230, a second end of the additional conducting layer 48 may be arranged below the second source electrode 412. The additional conducting layer 48 may be electrically coupled to the source regions 31 and body regions 32 of the sensor cells 30s by means of contact plugs 42₂ extending from the source regions 31 and body regions 32 to the additional conducting layer 48, and to the second source electrode 412 by means of additional contact plugs (not visible in the cross-sectional view of Figure 12) extending from the additional conducting layer 48 to the second source electrode 412.

While in the example illustrated in Figure 12 the sensor region 230 is covered by the first source electrode 411, it is also possible that parts of the active region 220 are covered by the second source electrode 412. This is schematically illustrated in Figure 13. In this case, at least some of the source regions 31 and body regions 32 of the transistor cells 30_{T} cannot be directly coupled to the first source electrode 411. The device, therefore, may comprise a second conducting layer 46. The source regions 31 and body regions 32 of the transistor cells 30_{T} may be electrically coupled to this second conducting layer 46 by means of contact plugs 42i. The second conducting layer 46 may be electrically coupled to the first source electrode 411 by means of additional contact plugs 42₃. The source regions 31 of the sensor cells 30s, similar to what has been described with respect to Figure 12 above, may be electrically coupled to an additional conducting layer 48 by means of contact plugs 42₂, and the additional conducting layer 48 may be electrically coupled to the second source electrode 412 by means of additional contact plugs 42₄.

As can be seen from the above, the first source electrode 411 and the second source electrode 412 may be arranged on the semiconductor body in any suitable position. The source regions 31 and body regions 32 of the transistor cells 30_{T} and of the sensor cells 30s may be electrically coupled to the respective source electrode 411, 412 either directly or via a conducting layer 46, 48. In this way, many different implementations are possible. The conducting layers 46, 48 may comprise at least one of polysilicon, tungsten, aluminum, copper, and a Ti/TiN barrier liner, for example.

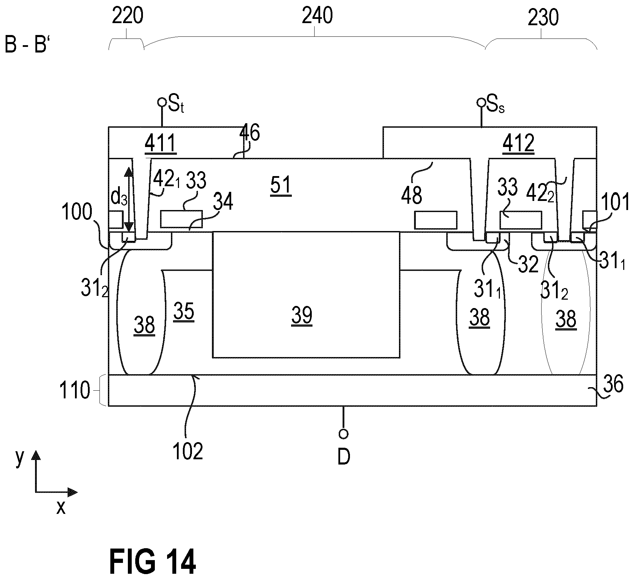

While in the examples illustrated in Figures 10 to 13 one of the compensation regions 38 directly adjoins the undoped semiconductor region 39 on each side in the first horizontal direction x, it is also possible that the undoped semiconductor region 39 adjoins one of the drift regions 35 on each side in the first horizontal direction x. This is schematically illustrated in Figure 14. The semiconductor device of Figure 14 is mostly identical with the semiconductor device that has been described with respect to Figure 7 above. In the example illustrated in Figure 14, however, the drift regions 35 directly adjoining the undoped semiconductor region 39 do not adjoin the first surface 101. A layer of the adjoining compensation region 38 is arranged vertically above the drift regions 35 and between the drift regions 35 and the first surface 101. That is, there is a small area below the first surface 101, where the closest compensation region 38 directly adjoins the undoped semiconductor layer 39.

## Claims

1. A semiconductor device, comprising:
a semiconductor body (100) comprising a first surface (101), a second surface (102) opposite to the first surface (101) in a vertical direction (y), an active region (220), and a sensor region (230) arranged adjacent to the active region (220) in a horizontal direction (x, z);
a plurality of transistor cells (30_{T}) at least partly integrated in the active region (220), each transistor cell (30_{T}) comprising a source region (31), a body region (32), a drift region (35) separated from the source region (31) by the body region (32), and a gate electrode (33) dielectrically insulated from the body region (32);
at least one sensor cell (30s) at least partly integrated in the sensor region (230), each of the at least one sensor cell (30s) comprising a source region (31), a body region (32), a drift region (35) separated from the source region (31) by the body region (32), and a gate electrode (33) dielectrically insulated from the body region (32); and
an intermediate region (240) arranged between the active region (220) and the sensor region (230), the intermediate region (240) comprising a drift region (35) and an undoped semiconductor region (39) extending from the first surface (101) into the drift region (35).

2. The semiconductor device of claim 1, wherein
each of the plurality of transistor cells (30_{T}) further comprises a compensation region (38) of a doping type complementary to the doping type of the drift region (35) and extending from a respective body region (32) into the drift region (35) in the vertical direction (y); and
each of the at least one sensor cell (30s) further comprises a compensation region (38) of a doping type complementary to the doping type of the drift region (35) and extending from a respective body region (32) into the drift region (35) in the vertical direction (y).

3. The semiconductor device of claim 1 or 2, wherein
the gate electrodes (33) of the plurality of transistor cells (30_{T}) and the gate electrodes (33) of the at least one sensor cell (30s) are coupled to a common gate pad (45), and
the drift regions (35) of the plurality of transistor cells (30_{T}) and the drift regions (35) of the at least one sensor cell (30s) are coupled to a common drain region (36).

4. The semiconductor device of any of claims 1 to 3, wherein
each of the plurality of transistor cells (30_{T}) has a first width (si) in a first horizontal direction (x), and
the undoped semiconductor region (39) has a third width (_{S3}) in the first horizontal direction (x) which is between one and 20 times the first width (si).

5. The semiconductor device of claim 4, wherein
each of the at least one sensor cell (30s) has a second width (_{S2}) in the first horizontal direction (x), and
the first width (si) equals the second width (s₂).

6. The semiconductor device of any of claims 1 to 5, wherein the intermediate region (240) further comprises
a first transition zone arranged between the active region (220) and the undoped semiconductor region (39); and
a second transition zone arranged between the sensor region (230) and the undoped semiconductor region (39).

7. The semiconductor device of claim 6, further comprising first and second base regions (321) and a junction termination region (90), wherein
the first base region (321) extends from the first surface (101) into the semiconductor body (100) in the vertical direction (y), and from the active region (220) through the first transition zone to the undoped semiconductor region (39) in the horizontal direction (x), and,
the second base region (321) extends from the first surface (101) into the semiconductor body (100) in the vertical direction (y), and from the sensor region (230) through the second transition zone to the undoped semiconductor region (39) in the horizontal direction (x), and
the junction termination region (90) extends from the first surface (101) into the semiconductor body (100) in the vertical direction (y), and from the first base region (321) to the second base region (321) in the horizontal direction (x) such that it is arranged between the undoped semiconductor region (39) and the first surface (101).

8. The semiconductor device of any of the preceding claims, wherein the undoped semiconductor region (39) is separated from the second surface (102) by a section of the drift region (35).

9. The semiconductor device of any of claims 1 to 6, wherein the plurality of transistor cells (30_{T}) comprises
a plurality of standard transistor cells (30_{T}), the drift region (35) of each of the plurality of standard transistor cells (30_{T}) having a first doping concentration;
at least one standard sensor cell (30s), the drift region (35) of each of the plurality of standard sensor cells (30s) having a second doping concentration,
and at least two transition cells, the drift region (35) of each of the transition cells having a third doping concentration that is lower than the first doping concentration and lower than the second doping concentration, wherein
at least one of the transition cells is arranged between the intermediate region (240) and at least a subset of the plurality of standard transistor cells (30_{T}), and
at least one of the transition cells is arranged between the intermediate region (240) and the standard sensor cells (30s).

10. The semiconductor device of claim 9, wherein
a first plurality of transition cells is arranged between the standard transistor cells (30_{T}) and the intermediate region (240), wherein a doping concentration of the different transition cells decreases from the standard transistor cells (30_{T}) towards the intermediate region (240), and
a second plurality of transition cells is arranged between the standard sensor cells (30s) and the intermediate region (240), wherein a doping concentration of the different transition cells decreases from the standard sensor cells (30s) towards the intermediate region (240).

11. The semiconductor device of claim 10, wherein
the first plurality comprises between 2 and 4, or between 2 and 14 transition cells, and
the second plurality comprises between 2 and 4, or between 2 and 14 transition cells.

12. The semiconductor device of any of the preceding claims, wherein
the source regions (31) of the plurality of transistor cells (30_{T}) are coupled to a first source electrode (411), and the source regions (31) of the at least one sensor cell (30s) are coupled to a second source electrode (412) separate and distant from the first source electrode (411).

13. The semiconductor device of any of the preceding claims, wherein the sensor region (230) is horizontally surrounded by the active region (220).

14. A method for forming a semiconductor device, the method comprising:
forming a plurality of transistor cells (30_{T}) in a semiconductor body (100), the semiconductor body (100) comprising a first surface (101), a second surface (102) opposite to the first surface (101) in a vertical direction (y), an active region (220), and a sensor region (230) arranged adjacent to the active region (220) in a horizontal direction (x, z), wherein the plurality of transistor cells (30_{T}) is at least partly integrated in the active region (220), and wherein each transistor cell (30_{T}) comprises a source region (31), a body region (32), a drift region (35) separated from the source region (31) by the body region (32), and a gate electrode (33) dielectrically insulated from the body region (32);
forming at least one sensor cell (30s), wherein the at least one sensor cell (30s) is at least partly integrated in the sensor region (230), and wherein each of the at least one sensor cell (30s) comprises a source region (31), a body region (32), a drift region (35) separated from the source region (31) by the body region (32), and a gate electrode (33) dielectrically insulated from the body region (32); and
forming an intermediate region (240) between the active region (220) and the sensor region (230), the intermediate region (240) comprising a drift region (35) and an undoped semiconductor region (39) extending from the first surface (101) into the drift region (35).
